# FASCICULE DE BREVET EUROPEEN

(11) **EP 0 574 292 B1**
(45) Date de publication et mention de la délivrance du brevet: **20.05.1998**
(21) Numéro de dépôt: 93401437.4
(22) Date de dépôt: 04.06.1993
(51) Int. Cl.: H03L 7/091

(54) **Procédé et dispositif d'asservissement en fréquence et phase d'un oscillateur**
Verfahren und Einrichtung zur Frequenz- und Phasenverriegelung eines Oszillators
Process and device for phase and frequency locking of an oscillator

(30) Priorité: 11.06.1992 FR 9207059
(43) Date de publication de la demande: 15.12.1993
(73) Titulaire: SGS-THOMSON MICROELECTRONICS S.A., 94253 Gentilly Cédex (FR)
(72) Inventeur: Gerot, Guy, F-78860 Saint Nom La Breteche (FR); Blouin, Pascal, F-35580 Lassy (FR)
(74) Mandataire: Michelet, Alain

(56) Documents cités:
- EP-A- 0 230 900
- EP-A- 0 467 306
- GB-A- 2 246 036

## Description

La présente invention telle qu'elle est définie dans les revendications est relative à un procédé et à un dispositif d'asservissement en fréquence et phase d'un oscillateur et notamment d'un oscillateur à quartz contrôlé en tension. Plus particulièrement, le procédé et le dispositif proposés par l'invention permettent d'asservir un oscillateur à quartz à partir d'un signal extérieur transmis sous forme de salves périodiques.

Les oscillateurs à quartz à fréquence contrôlée en tension sont depuis longtemps connus. Il a notamment été proposé par le brevet FR-1.473.273 un oscillateur à quartz contrôlé en fréquence en fonction d'un signal électrique de commande telle qu'une tension, dont les variations produisent sur l'oscillateur des variations quasi-linéaires de fréquence. Des circuits d'oscillateurs à quartz de ce type ont encore été décrits plus récemment dans les demandes de brevet FR-2.569.505 et EP-466.388. Le document EP-A-0 230 900 divulgue également un dispositif d'asservissement en phase d'un oscillateur.

Des dispositifs d'asservissement en fréquence et phase d'un oscillateur à quartz sur un signal de référence sont également depuis longtemps connus. On peut à cet égard se reporter à la demande de brevet français déposée au nom de THOMSON-CSF et publiée sous le N° FR-2.620.878, dans laquelle il est proposé un oscillateur à quartz asservi en fréquence par effet thermique. Des moyens de chauffage du quartz y sont notamment prévus pour, en fonction d'un écart de fréquence et de phase mesuré, modifier la température du quartz et donc sa fréquence de fonctionnement. D'autres oscillateurs à quartz contrôlés en température ont encore été décrits dans la demande de brevet EP-401.919.

Des boucles d'asservissement particulières pour le calage d'une oscillation stable à court terme sur une oscillation stable à long terme sont encore connues par les demandes de brevet FR-2.626.686 et FR-2.614.116 et utilisées par exemple dans le domaine des télécommunications pour faire coïncider des fréquences de travail avec des fréquences d'étalon atomique.

La demande de brevet européen EP-0.230.900 décrit un dispositif de récupération de rythme dans lequel, selon un mode de réalisation, le signal est échantillonné, numérisé. Le signe du signal, ainsi que celui de l'erreur estimée, sont alors déterminés et adressés sur une logique séquentielle.

Cette logique fournit par l'intermédiaire d'un interface logique analogique un signal de commande de l'échantillonneur.

On remarque, dans ce dispositif, que seul le signe de l'erreur estimée est pris en considération.

La présente invention propose quant à elle un procédé et un dispositif d'asservissement en fréquence et phase d'un oscillateur, notamment à quartz contrôlé en tension, qui est d'un type nouveau et dont un avantage principal est de permettre de traiter de façon principalement numérique la boucle d'asservissement dudit oscillateur à quartz.

La présente invention a donc pour objet un procédé d'asservissement en fréquence et en phase, à partir d'un signal de référence, d'un oscillateur contrôlé en fréquence et en phase par une grandeur physique de commande dans lequel:
le signal de référence étant un signal aléatoire à plusieurs niveaux, de fréquence et de phase données, ledit signal de référence est séquencé,
l'erreur de phase entre l'oscillateur et le signal de référence est déterminée pour au moins une séquence de signal de référence, et
un signal de correction est généré en fonction de cette erreur de phase pour corriger la grandeur physique de commande.
Il comporte la succession d'étapes:
le signal de référence est échantillonné par un signal d'horloge émis par l'oscillateur,
le signal échantillonné ainsi obtenu est numérisé,
l'on déduit pour une séquence dudit signal numérisé, une valeur représentative de l'erreur de phase du signal synthétisé par l'oscillateur par rapport au signal de référence,
l'on déduit de cette valeur numérique représentative de l'erreur de phase, une valeur de correction dont on corrige une valeur numérique représentant la grandeur de commande,
l'on convertit cette valeur numérique représentant la grandeur de commande en ladite grandeur, et
l'on applique cette grandeur physique à l'oscillateur pour le commander en fréquence et en phase.

Selon l'invention, la valeur de correction dont on corrige la valeur numérique représentant la grandeur de commande est calculée en fonction de l'amplitude de l'erreur de phase et de sa variation d'une séquence de signal à l'autre.

Ce procédé est avantageusement complété par les différentes caractéristiques suivantes prises seules ou selon toutes leurs combinaisons techniquement possibles:
- la grandeur physique commandant l'oscillateur est une tension;
- pour calculer une valeur représentative de l'erreur de phase, on détermine des valeurs de signal échantillonné correspondant à des transitions entre différents seuils pour ledit signal échantillonné et on calcule une moyenne des valeurs des échantillons ainsi déterminées;
- pour calculer une valeur représentative de l'erreur de phase, on calcule la différence entre une valeur moyenne d'échantillons correspondant à des transitions croissantes et une valeur moyenne d'échantillons correspondant à des transitions décroissantes;
- la fréquence du séquençage du signal de référence est choisie pour qu'en moyenne, on détecte sur une séquence un nombre équivalent de transitions croissantes et de transitions décroissantes;
- pour calculer la valeur de correction, on compare les deux dernières valeurs représentatives d'erreur de phase obtenues, et
   - si l'on constate que l'erreur de phase est croissante et positive, on génère une valeur de correction positive proportionnelle à la différence entre les valeurs représentatives d'erreur de phase;
   - si l'on constate que l'erreur de phase est croissante et négative, on génère une valeur de correction proportionnelle à la différence des valeurs représentatives d'erreur de phase;
   - si l'on constate que l'erreur de phase est constante et strictement positive, on génère une valeur de correction positive élémentaire;
   - si l'on constate que l'erreur de phase est constante et strictement négative, l'on génère une valeur de correction négative élémentaire;
- une zone morte correspondant à des valeurs représentatives de l'erreur de phase pour lesquelles la boucle d'asservissement n'est pas activée, est préalablement déterminée.

L'invention a encore pour objet un dispositif d'asservissement en fréquence et en phase à partir d'un signal de référence, d'un oscillateur contrôlé en fréquence et en phase par une grandeur physique, caractérisé en ce qu'il comprend principalement un convertisseur analogique numérique pour échantillonner ledit signal de référence par un signal d'échantillonnage généré par l'horloge de l'oscillateur, des moyens de calcul numérique de valeurs représentatives de l'erreur de phase, des moyens pour le calcul d'une valeur de correction, en fonction des différentes valeurs représentatives d'erreurs de phase calculées, d'une valeur représentative de la grandeur commandant l'oscillateur, un intégrateur numérique-analogique pour transformer cette valeur corrigée en la grandeur de commande et appliquer ladite grandeur de commande à l'entrée de l'oscillateur.

Avantageusement, pour le calcul d'une valeur représentative d'erreurs de phase, il comporte des moyens détecteurs de niveaux et de transitions sur lesquels sont envoyés les signaux échantillonnés, ainsi que des moyens formant registres mémoires pour les échantillons, lesdits moyens détecteurs de niveaux et de transitions envoyant sur lesdits moyens formant registres des ordres de sélection pour les échantillons correspondant à des transitions pour le signal échantillonné, les valeurs des échantillons ainsi sélectionnées étant ensuite moyennées pour obtenir une valeur représentative de l'erreur de phase.

De préférence, les moyens formant détecteurs de transition sont des moyens formant détecteurs de transition croissantes d'une part et de transitions décroissantes d'autre part et en ce que les moyens de moyennage réalisent une moyenne de transitions croissantes et de transitions décroissantes ainsi qu'une soustraction de ces deux moyennes.

Un autre objet encore de l'invention est un oscillateur à quartz contrôlé en tension comportant un dispositif de ce type.

La description qui suit d'un mode de réalisation particulier de l'invention est purement illustrative et non limitative. Elle doit être lue en regard des dessins annexés sur lesquels:
La Figure 1 est une représentation synoptique illustrant le procédé et le dispositif pour l'asservissement d'un oscillateur conformes à l'invention;
Les Figures 2a et 2b représentent respectivement d'une part le signal de référence par lequel est réalisé l'asservissement dudit oscillateur et d'autre part un signal d'échantillonnage délivré par l'horloge dudit oscillateur;
La Figure 2c, enfin illustre schématiquement le calcul de l'erreur de phase entre l'oscillateur et le signal de référence.

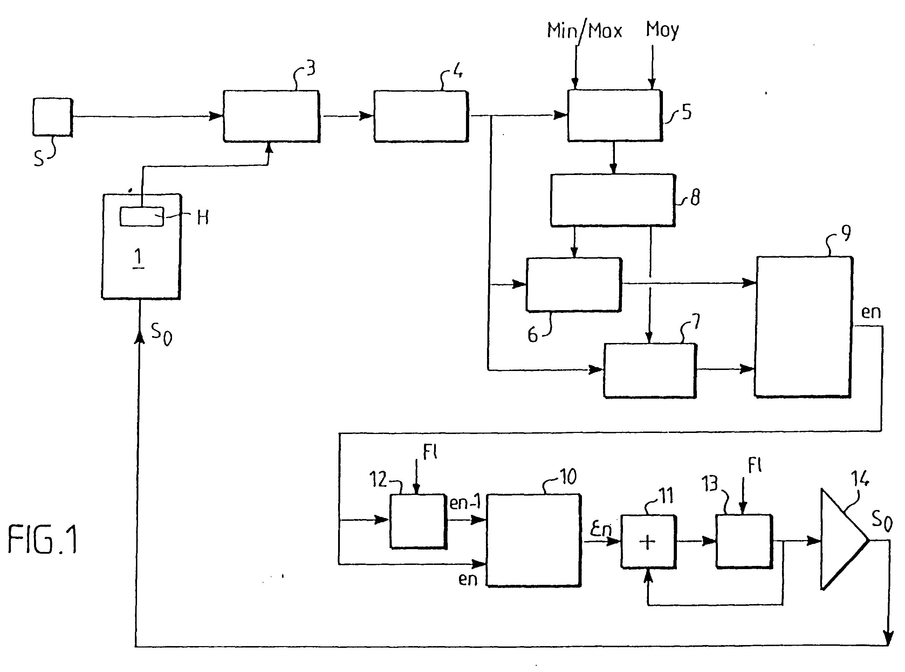

Sur la Figure 1, on voit que le dispositif d'asservissement d'un oscillateur 1 à quartz contrôlé en tension qui y est représenté comprend principalement un convertisseur analogique-numérique 3 recevant d'une part un signal d'échantillonnage que lui envoie l'horloge H de l'oscillateur 1 et d'autre part un signal de référence que lui transmet une source ou un récepteur S. Ce signal de référence, appelé signal S dans toute la suite du texte est un signal aléatoire à plusieurs niveaux, par exemple duobinaire. Le signal en sortie de ce convertisseur analogique-numérique 3 est un signal E échantillonné et numérisé.

Le signal numérique en sortie de ce convertisseur 3 est envoyé sur un filtre de Nyquist 4 permettant dans certaines applications particulières de sélectionner les bandes passantes de travail.

Le signal numérique est ensuite envoyé d'une part sur un détecteur 5 de niveau et d'autre part sur deux registres mémoires d'échantillons 6 et 7. Le détecteur de niveau 5 est un détecteur à seuils paramétré avec une valeur moyenne Moy et des valeurs maximum et minimum Max et Min. Il est couplé à un détecteur de transitions 8 qui, aux transitions montantes, envoie un ordre de sélection sur le registre d'échantillons 6 et aux transitions descendantes envoie un ordre de sélection sur le registre d'échantillons 7.

Le dispositif de l'invention est particulièrement bien adapté aux traitements de signaux de télévision, par exemple définis selon la norme D2MAC. On sait qu'un tel signal inclut des séquences de référence permettant de situer ses valeurs, qui peuvent varier entre un niveau minimum dit niveau de noir et un niveau maximum dit niveau de blanc.

Les valeurs maximum et minimum exploitées selon le procédé de l'invention correspondent alors à ces niveaux de noir et ces niveaux de blanc.

En sortie des registres 6 et 7, les échantillons correspondant respectivement aux transitions montantes et aux transitions descendantes détectées sont envoyés sur un bloc de moyennage 9. Ce bloc de moyennage 9 donne, en fonction d'une fréquence de séquençage initialement choisie, une valeur correspondant à une valeur moyenne représentative de l'erreur de phase de la séquence de signal examinée.

La valeur moyenne eₙ d'erreur de phase de la n^{ième} séquence de signal est ensuite envoyée sur un bloc d'algorithme 10 qui en fonction de cette valeur eₙ et de la valeur eₙ₋₁ de la n-1 ième séquence de signal mémorisée au niveau d'une ligne de retard 12, calcule une valeur de correction εₙ Cette valeur de correction εₙ est sommée, par une boucle classique à sommateur 11 et retard 13, à la valeur de sortie de cette boucle obtenue par la séquence de signal précédente.

La valeur sommée ainsi obtenue est ensuite envoyée sur un intégrateur 14 numérique-analogique qui la transforme en une tension So appliquée à l'oscillateur pour son contrôle en phase et en fréquence.

Le fonctionnement de ce dispositif va maintenant être explicité plus en détail.

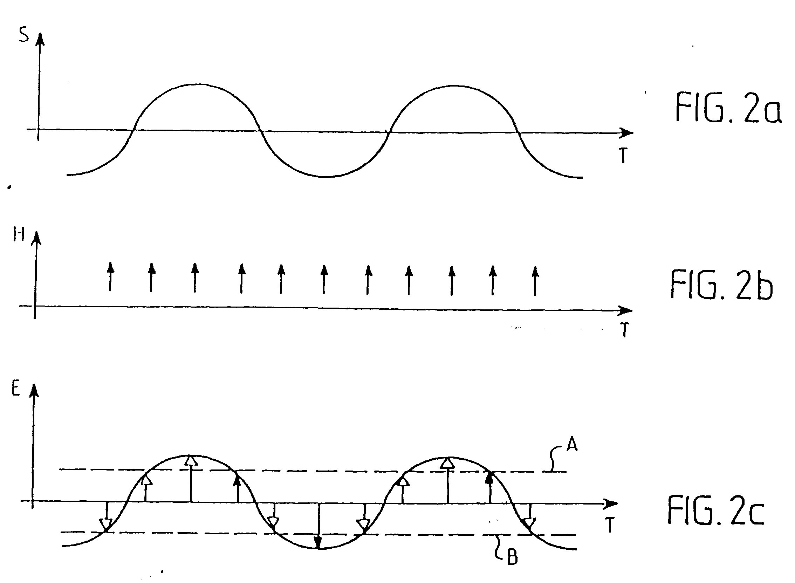

Le signal S représenté sur la Figure 2a qui sert de signal de référence, est choisi à titre d'exemple sinusoïdal. Il est échantillonné au niveau du convertisseur analogique-numérique 3 par le signal de l'horloge H représenté sur la Figure 2b. Le signal E ainsi échantillonné et numérisé, qui correspond aux flèches qui ont été représentées sur la Figure 2c, est ensuite envoyé sur les détecteurs 5 et 8 où des niveaux de signal sont d'abord détectés, puis où des transitions sont repérés. On a représenté à titre d'exemple sur la Figure 2c deux niveaux A et B de détection, une transition étant détectée lorsque les valeurs échantillonnées passent de au-dessus à en-dessous d'un tel niveau ou inversement. A titre d'exemple, les flèches foncées représentées sur la Figure 2c sont les échantillons qui correspondent aux transitions descendantes détectées et donc aux valeurs qui sont envoyées sur le registre 7.

Le bloc de moyennage 9 réalise pour une séquence donnée, la somme des transitions montantes, la somme des transitions descendantes, puis soustrait ces deux sommes et les divise par le nombre de transitions détectées dans la séquence. La fréquence Fl de séquençage est initialement choisie pour qu'a priori, en moyenne, une séquence comporte huit transitions montantes et huit transitions descendantes. Cette fréquence Fl est appliquée aux blocs de retard 12 et 13. La valeur eₙ ainsi obtenue est une valeur moyenne du signal de référence 9, significative de l'erreur de phase et affranchie de l'erreur éventuelle qui a pu être faite sur la place de la valeur moyenne, c'est-à-dire du zéro dans le cas d'un signal sinusoïdal, au niveau du détecteur à seuil 5.

Cette erreur de phase eₙ est alors comparée dans le bloc algorithme 10 à l'erreur eₙ₋₁ sur la ligne courante (ou séquence de signal) précédente:
- Si ligne à ligne, l'erreur de phase est croissante et positive, la fréquence du signal synthétisée par l'oscillateur à quartz 1 est inférieure à la fréquence du signal de référence ou fréquence nominale. Une valeur de correction positive εₙ proportionnelle à la différence de phase mesurée entre deux lignes est générée.
- Si ligne à ligne, l'erreur de phase est décroissante et négative, la fréquence du signal synthétisée par l'oscillateur à quartz 1 est supérieure à la fréquence nominale. Une valeur de correction εₙ négative proportionnelle à la différence de phase mesurée entre deux lignes est généré.
- Si ligne à ligne, l'erreur de phase est constante et strictement positive, la fréquence du signal à régénérer par l'oscillateur à quartz 1 est égale à la fréquence du signal de référence, mais sa phase est erronée. Une valeur de correction positive εₙ, correspondant à un décalage élémentaire est générée pour accroître la fréquence et récupérer la phase correcte.
- Si ligne à ligne, l'erreur de phase est constante et strictement négative, la fréquence du signal régénéré par l'oscillateur à quartz 1 est égale à la fréquence du signal de référence, mais sa phase est erronée. Une valeur de correction négative εₙ égale à un décalage élémentaire est générée pour accroître la fréquence du signal de synthèse et récupérer la phase correcte.

La zone morte, dans laquelle on considère que le signal de synthèse émis par l'oscillateur à quartz 1 est correctement calé sur le signal de référence, est choisie par exemple comme correspondant à des valeurs eₙ représentatives de l'erreur de phase comprises entre -0,8 et +0,8. Ces valeurs ne sont données qu'à titre d'exemple et seront déterminées au cas par cas en fonction des besoins des utilisateurs. Dans l'exemple ici donné, sur un codage 8 ou 9 bits, la boucle d'asservissement sera activée:
- dès que l'erreur de phase passera de 0 à -1 ou de +1 à 0, auquel cas la phase étant correcte, mais la fréquence trop élevée, un signal d'erreur εₙ négatif égal à un décalage élémentaire sera généré afin de diminuer la fréquence,
- ou dès que l'erreur de phase passera de -1 à 0 ou de 0 à +1, auquel cas la phase étant correcte mais la fréquence trop basse, un signal d'erreur positif εₙ égal à un décalage élémentaire sera généré afin d'augmenter la fréquence.

Dans le cas d'un codage 9 bits, avec les valeurs choisies comme bornes pour la zone morte, la zone morte effective correspondra à l'intervalle (-05, +05). Dans le cas d'un codage 8 bits, la zone morte correspondra uniquement à la valeur zéro.

Les signes de référence insérés après les caractéristiques techniques mentionnées dans les revendications, ont pour seul but de faciliter la compréhension de ces dernières, et n'en limitent aucunement la portée.

## Revendications

1. Procédé d'asservissement en fréquence et en phase, à partir d'un signal de référence (S), d'un oscillateur (1) contrôlé en fréquence et en phase par une grandeur physique (Sₒ) de commande dans lequel:
le signal de référence étant un signal aléatoire à plusieurs niveaux, de fréquence et de phase données,
ledit signal de référence est séquencé,
l'erreur de phase (eₙ) entre l'oscillateur (1) et le signal de référence (S) est déterminée pour au moins une séquence de signal de référence (S), et
un signal de correction (eₙ) est généré en fonction de cette erreur de phase pour corriger la grandeur physique de commande (Sₒ),
comportant la succession d'étapes suivantes:
le signal de référence (S) est échantillonné par un signal d'horloge (H) émis par l'oscillateur (1),
le signal échantillonné ainsi obtenu est numérisé (E), l'on déduit pour une séquence dudit signal numérisé, une valeur représentative de l'erreur de phase (eₙ) du signal synthétisé par l'oscillateur (1) par rapport au signal de référence (S),
l'on déduit de cette valeur numérique (eₙ) représentative de l'erreur de phase, une valeur de correction (εₙ) dont on corrige une valeur numérique représentant la grandeur de commande (Sₒ),
l'on convertit cette valeur numérique représentant la grandeur de commande en ladite grandeur (Sₒ), et
l'on applique cette grandeur physique (Sₒ) à l'oscillateur (1) pour le commander en fréquence et en phase,
caractérisé en ce que la valeur de correction (εₙ), dont on corrige la valeur numérique représentant la grandeur de commande (Sₒ), est calculée en fonction de l'amplitude de l'erreur de phase (eₙ) et de sa variation d'une séquence de signal à l'autre.

2. Procédé selon la revendication 1, caractérisé en ce que la grandeur physique (Sₒ) commandant l'oscillateur (1) est une tension.

3. Procédé selon l'une des revendications 1 ou 2, caractérisé en ce que pour calculer une valeur représentative de l'erreur de phase (eₙ), on détermine des valeurs de signal échantillonné (E) correspondant à des transitions entre différents seuils (A, B) pour ledit signal échantillonné (E) et on calcule ladite valeur représentative à partir des valeurs des échantillons ainsi déterminées.

4. Procédé selon la revendication 3, caractérisé en ce que pour calculer une valeur (eₙ) représentative de l'erreur de phase, on calcule la différence entre une valeur moyenne d'échantillons correspondant à des transitions croissantes et une valeur moyenne d'échantillons correspondant à des transitions décroissantes.

5. Procédé selon la revendication 4, caractérisé en ce que la fréquence du séquençage du signal de référence (S) est choisi pour qu'en moyenne sur une séquence on détecte le même nombre de transitions croissantes et de transitions décroissantes.

6. Procédé selon l'une quelconque des revendications précédentes, caractérisé en ce que pour calculer la valeur de correction (εₙ), on compare les deux dernières valeurs représentatives d'erreur de phase (eₙ) obtenues et:
- si l'on constate que l'erreur de phase (eₙ) est croissante et positive, on génère une valeur de correction (εₙ) positive proportionnelle à la différence entre les valeurs représentatives d'erreur de phase;
- si l'on constate que l'erreur de phase (eₙ) est croissante et négative, on génère une valeur de correction (eₙ) proportionnelle à la différence des valeurs représentatives d'erreur de phase;
- si l'on constate que l'erreur de phase (eₙ) est constante et strictement positive, on génère une valeur de correction (εₙ) positive élémentaire;
- si l'on constate que l'erreur de phase (eₙ) est constante et strictement négative, l'on génère une valeur de correction (εₙ) négative élémentaire.

7. Procédé selon l'une quelconque des revendications précédentes, caractérisé en ce qu'une zone morte correspondant à des valeurs représentatives de l'erreur de phase (eₙ) pour lesquelles la boucle d'asservissement n'est pas activée, est préalablement déterminée.

8. Dispositif d'asservissement en fréquence et en phase à partir d'un signal de référence (S), d'un oscillateur (1) contrôlé en fréquence et en phase par une grandeur physique (Sₒ), caractérisé en ce qu'il comprend principalement un convertisseur analogique-numérique (3) pour échantillonner ledit signal de référence (S) par un signal d'échantillonnage (H) généré par l'horloge de l'oscillateur (1), le signal étant (E) ainsi échantillonné et numérisé, des moyens (5, 6, 7, 8, 9) de calcul numérique de valeurs représentatives de l'erreur de phase (eₙ), des moyens pour le calcul d'une valeur de correction (εₙ), en fonction des différentes valeurs représentatives d'erreurs de phase (eₙ) calculées, d'une valeur représentative de la grandeur (Sₒ) commandant l'oscillateur, un intégrateur (14) numérique-analogique pour transformer cette valeur corrigée en la grandeur de commande (Sₒ) et appliquer ladite grandeur de commande à l'entrée de l'oscillateur (1).

9. Dispositif selon la revendication 8, caractérisé en ce que pour le calcul d'une valeur représentative d'erreurs de phase (eₙ), il comporte des moyens (5, 8) détecteurs de niveaux et de transitions sur lesquels sont envoyés les signaux (E) échantillonnés et numérisés, ainsi que des moyens (6, 7) formant registres mémoires pour les échantillons, lesdits moyens (5, 8) détecteurs de niveaux et de transitions envoyant sur lesdits moyens (6, 7) formant registres des ordres de sélection pour les échantillons correspondant à des transitions pour le signal échantillonné et numérisé (E), les valeurs des échantillons ainsi sélectionnées étant ensuite moyennées pour obtenir une valeur représentative de l'erreur de phase (eₙ).

10. Dispositif selon la revendication 9, caractérisé en ce que les moyens (8) formant détecteurs de transition sont des moyens formant détecteurs de transition croissantes d'une part et de transitions décroissantes d'autre part et en ce que les moyens de moyennage (9) réalisant une moyenne de transitions croissantes et de transitions décroissantes ainsi qu'une soustraction de ces deux moyennes.

11. Oscillateur à quartz contrôlé en tension comportant un dispositif selon l'une des revendications 8 à 10.

## Patentansprüche

1. Auf Basis eines Referenzsignals (S) erfolgendes Frequenz- und Phasenregelungsverfahren für einen Oszillator (1), der mittels einer physikalischen Steuergröße (Sₒ) frequenz- und phasengesteuert wird, bei dem:
das Referenzsignal ein Zufallssignal mit mehreren Pegeln mit vorgegebener Frequenz und Phase ist, wobei das Referenzsignal in Folgen unterteilt ist,
der Phasenfehler (eₙ) zwischen dem Oszillator (1) und dem Referenzsignal (S) für mindestens eine Folge des Referenzsignals (S) bestimmt wird, und
als Funktion dieses Phasenfehlers ein Korrektursignal (Eₙ) zum Korrigieren der physikalischen Steuergröße (Sₒ) erzeugt wird,
mit den folgenden aufeinanderfolgenden Schritten:
Abtasten des Referenzsignals (S) mit Hilfe eines von dem Oszillator (1) ausgegebenen Taktsignals (H),
Digitalisieren (E) des derart erhaltenen Tastsignals,
für eine Folge des digitalisierten Signals, Errechnen eines Wertes, der den Phasenfehler (eₙ) des durch den Oszillator (1) erzeugten Signals repräsentiert, auf der Basis des Referenzsignals (S),
Errechnen eines Korrekturwertes (Eₙ), mit dem ein die Steuergröße (Sₒ) repräsentierender numerischer Wert korrigiert wird, aus dem den Phasenfehler repräsentierenden numerischen Wert (eₙ) ,
Konvertieren des die Steuergröße repräsentierenden numerischen Wertes zu der genannten Größe (Sₒ), und
Zuführen dieser physikalischen Größe (Sₒ) zu dem Oszillator (1), um diesen frequenz- und phasenzusteuern,
dadurch gekennzeichnet, daß der Korrekturwert (Eₙ), mit dem der die Steuergröße (Sₒ) repräsentierende numerische Wert korrigiert wird, als Funktion der Amplitude des Phasenfehlers (eₙ) und deren Veränderung von einer Signalfolge zur nächsten berechnet wird.

2. Verfahren nach Anspruch 1, dadurch gekennzeichnet, daß die den Oszillator (1) steuerende physikalische Größe (Sₒ) eine Spannung ist.

3. Verfahren nach Anspruch 1 oder 2, dadurch gekennzeichnet, daß zur Berechnung eines den Phasenfehler (eₙ) repräsentierenden Wertes Werte des Tastsignals (E) bestimmt werden, die den Übergängen zwischen unterschiedlichen Schwellenwerten (A,B) für das Tastsignal (E) entsprechen, und dieser repräsentierende Wert auf der Basis der derart bestimmten Tastsignale berechnet wird.

4. Verfahren nach Anspruch 3, dadurch gekennzeichnet, daß zur Berechnung eines den Phasenfehler repräsentierenden Wertes (eₙ) die Differenz zwischen einem Mittelwert von Tastsignalen, die zunehmenden Übergängen entsprechen, und einem Mittelwert von Tastsignalen berechnet wird, die abnehmenden Übergängen entsprechen.

5. Verfahren nach Anspruch 4, dadurch gekennzeichnet, daß die Folgefrequenz des Referenzsignals (S) derart gewählt ist, daß im Durchschnitt in einer Folge die gleiche Anzahl zunehmender Übergänge und abnehmender Übergänge detektiert wird.

6. Verfahren nach einem der vorhergehenden Ansprüche, dadurch gekennzeichnet, daß zur Berechnung des Korrekturwertes (Eₙ) die beiden zuletzt erhaltenen, den Phasenfehler (eₙ) repräsentierenden Werte verglichen werden, und:
- falls festgestellt wird, daß der Phasenfehler (eₙ) zunimmt und positiv ist, ein positiver Korrekturwert (Eₙ) erzeugt wird, der der Differenz zwischen den die Phasenfehler repräsentierenden Werten proportional ist;
- falls festgestellt wird, daß der Phasenfehler (eₙ) zunimmt und negativ ist, ein Korrekturwert (Eₙ) erzeugt wird, der der Differenz zwischen den die Phasenfehler repräsentierenden Werten proportional ist;
- falls festgestellt wird, daß der Phasenfehler (eₙ) konstant und strikt positiv ist, ein positiver elementarer Korrekturwert (Eₙ) erzeugt wird;
- falls festgestellt wird, daß der Phasenfehler (eₙ) konstant und strikt negativ ist, ein negativer elementarer Korrekturwert (Eₙ) erzeugt wird.

7. Verfahren nach einem der vorhergehenden Ansprüche, dadurch gekennzeichnet, daß ein Totbereich voreingestellt ist, der den Phasenfehler (eₙ) repräsentierenden Werten entspricht, bei denen der Regelkreis nicht aktiv ist.

8. Vorrichtung zur auf Basis eines Referenzsignals (S) erfolgenden Frequenz- und Phasenregelung eines Oszillators (1), der mittels einer physikalischen Steuergröße (Sₒ) frequenz- und phasengesteuert wird,
dadurch gekennzeichnet, daß die Vorrichtung hauptsächlich aufweist: einen Analog-/Digital-Konverter (3), um das Referenzsignal (S) durch ein Tastsignal (H) abzutasten, das durch den Taktgeber des Oszillators (1) erzeugt wird, wobei das Signal (E) somit abgetastet und digitalisiert wird, Einrichtungen (5,6,7,8,9) zur numerischen Berechnung von Werten, die den Phasenfehler (eₙ) repräsentieren, Einrichtungen zur Berechnung eines Korrekturwertes (Eₙ) als Funktion verschiedener Werte, welche Phasenfehler (eₙ) repräsentieren, und eines Wertes, der die Steuergröße (Sₒ) des Ozillators repräsentiert, einen Digital-/Analog-Integrator (14), um den korigierten Wert in die Steuergröße (Sₒ) umzusetzen und die Steuergröße dem Eingang des Oszillators (1) zuzuführen.

9. Vorrichtung nach Anspruch 8, dadurch gekennzeichnet, daß die Vorrichtung zwecks Berechnung eines die Phasenfehler (eₙ) repräsentierenden Wertes aufweist: Einrichtungen (5,8) zum Detektieren der Pegel und der Übergänge, denen die abgetasteten und digitalisierten Signale (E) zugeführt werden, und Einrichtungen (6,7), die Speicherregister für die Tastsignale bilden, wobei die zum Detektieren der Pegel und der Übergänge vorgesehenen Einrichtungen (5,8) mit den Einrichtungen (6,7) verbunden sind, die Register der Wahlabfolgen der Tastwerte bilden, welche Übergängen des abgetasteten und digitalisierten Signals (E) entsprechen, und wobei die Werte der so gewählten Tastsignale anschließend gemittelt werden, um einen den Phasenfehler (eₙ) repräsentierenden Wert zu erhalten.

10. Vorrichtung nach Anspruch 9, dadurch gekennzeichnet, daß die Einrichtung (8), die die Übergangs-Detektoren bildet, eine Einrichtung ist, die Detektoren einerseits für zunehmende Übergänge und andererseits für abnehmende Übergänge bildet, und daß die Mittelungseinrichtung (9) einen Mittelwert der zunehmenden Übergänge und einen Mittelwert der abnehmenden Übergänge erzeugen und eine Subtraktion der beiden Mittelwerte vornehmen.

11. Spannungsgesteuerter Quarzoszillator mit einer Vorrichtung nach einem der Ansprüche 8 bis 10.

## Claims

1. Process for slaving the frequency and phase of a crystal oscillator (1) against a reference signal (S), said crystal oscillator being controlled in frequency and phase by a physical control magnitude (Sₒ), and in which :
- the reference signal is a random signal of several levels, of given frequency and phase,
- said reference signal being sequenced,
- the phase error (eₙ) between the oscillator (1) and the reference signal (S) being determined for at least one reference signal sequence (S), and
- a correction signal (Eₙ) being generated to correct the physical control magnitude (Sₒ) according to this phase error,
wherein it comprises the following succession of stages :
- the reference signal (S) is sampled by a clock signal (H) sent by the oscillator (1),
- the sample signal thus obtained is digitized (E),
- a value representative of the phase error (eₙ) of the signal synthesized by the oscillator (1) relative to the reference signal (S) is then deduced for one sequence of the said digitized signal,
- a correction value (Eₙ) is then deduced from this digital value (eₙ) representative of the phase error and used to correct a digital value representing the control magnitude (Sₒ),
- this digital value representing the control magnitude is then converted into said magnitude (Sₒ), and
- this physical magnitude (Sₒ) is applied to the oscillator (1) to control its frequency and phase,
characterized in that the correction value (Eₙ) used to correct the digital value representing the control magnitude (Sₒ) is calculated according to the size of the phase error (eₙ) and its variation from one signal sequence to the next.

2. Process according to claim 1, characterized in that the physical magnitude (Sₒ) controlling the oscillator (1) is a voltage.

3. Process as claimed in either claims 1 or 2, characterized in that to calculate a value representative of the phase error (eₙ), sample signal values (E) are determined corresponding to transitions between different thresholds (A,B) for said sample signal (E) and said representative value is calculated from the sample values thus determined.

4. Process as claimed in claim 3, characterized in that to calculate a value (eₙ) representative of the phase error, the difference between a mean sample value corresponding to increasing transitions and a mean sample value corresponding to decreasing transitions is calculated.

5. Process as claimed in claim 4, characterized in that the sequencing frequency of the reference signal (S) is chosen so that on average, the same number of increasing transitions and decreasing transitions are detected on a sequence.

6. Process as claimed in any one of the preceding claims, characterized in that to calculate the correction value (Eₙ), the last two values obtained representative of the phase error (eₙ) are compared, and :
- if the phase error (eₙ) is found to be increasing and positive, a positive correction value (Eₙ) is generated that is proportional to the difference between the values representative of phase error;
- if the phase error (eₙ) is found to be increasing and negative, a correction value (Eₙ) is generated that is proportional to the difference between the values representative of phase error;
- if the phase error (eₙ) is found to be constant and strictly positive, an elementary positive correction value (Eₙ) is generated;
- if the phase error (eₙ) is found to be constant and strictly negative, an elementary negative correction value (Eₙ) is generated.

7. Process as claimed in any one of the preceding claims, characterized in that a dead zone is determined beforehand corresponding to values representative of the phase error (eₙ) for which the control loop is not activated.

8. Device for slaving the frequency and phase of a crystal oscillator (1) against a reference signal (S), said crystal oscillator being controlled in frequency and phase by a physical magnitude (Sₒ), characterized in that it mainly comprises an analogue-to-digital converter (3) to sample the said reference signal (S) by a sampling signal (H) generated by the clock of the oscillator (1), that signal (E) being thus sampled and digitized, means (5,6,7,8,9) for digitally calculating values representative of the phase error (eₙ), means for calculating a correction value (Eₙ) according to the different calculated values representative of phase errors (eₙ), of a value representative of the magnitude (Sₒ) controlling the oscillator, a digital-to-analogue integrator (14) to transform this corrected value into the control magnitude (Sₒ) and to apply said control magnitude to the input of the oscillator (1).

9. Device as claimed in claim 8, characterized in that for calculating a value representativeof phase errors (eₙ), it comprises means (5,8) for detecting levels and transitions to which the sampled and digitized signals are sent, in addition to means (6,7) forming memory registers for the samples, said means (5,8) for detecting levels and transitions sending selection orders to the said means (6,7) forming registers for the samples corresponding to transitions for the sampled and digitized signal (E), the mean of the values of the samples thus selected then being calculated to provide a value representative of the phase error (eₙ).

10. Device as claimed in claim 9, characterized in that the means (8) forming the transition detectors are, first, means forming increasing transition detectors and secondly, means forming decreasing transition detectors, and in that the mean determining means (9) provide the mean value of increasing transitions and the mean value of decreasing transitions and, by substraction, the difference between these two means values.

11. Voltage-controlled crystal oscillator comprising a device as claimed in any one of claims 8 to 10.
